# EUROPÄISCHE PATENTSCHRIFT

(11) **EP 0 766 092 B1**
(45) Veröffentlichungstag und Bekanntmachung des Hinweises auf die Patenterteilung: **01.12.2004**
(21) Anmeldenummer: 96115167.7
(22) Anmeldetag: 20.09.1996
(51) Int. Cl.: G01R 31/3185, G11C 29/00, G06F 11/16

(54) **Testbare Schaltungsanordnung mit mehreren identischen Schaltungsblöcken**
Testable circuit with multiple identical circuit blocks
Circuit testable ayant plusieurs blocs de circuit identiques

(30) Priorität: 28.09.1995 DE 19536226
(43) Veröffentlichungstag der Anmeldung: 02.04.1997
(73) Patentinhaber: Infineon Technologies AG, 81669 München (DE)
(72) Erfinder: Dallmann, Achim, Dipl.-Phys., 85598 Baldham (DE); Bode, Hans-Jörgen, Dipl.-Ing., 81669 München (DE)

(56) Entgegenhaltungen:
- EP-A- 0 059 789
- US-A- 5 459 738

## Beschreibung

Die Erfindung betrifft eine Schaltungsanordnung mit mehreren in beliebiger Weise miteinander verbundenen, identischen Schaltungsblöcken.

Die zunehmend dichtere Plazierung der Bauteile auf Montageträgern oder in integrierten Schaltkreisen läßt eine individuelle Kontaktierung für einen Funktionstest in Zukunft nicht länger zu. Somit sinken die Möglichkeiten einer Qualitätskontrolle oder einer schnellen Fehlerdiagnose vor Ort. Aus diesem Grund wurde von der Joint-Test-Action-Group (JTAG) ein Standard-Test-Access-Port und eine Boundary-Scan-Architecture definiert (vgl. IEEE Standard 1149.1/D6, Standard-Test-Access-Port and Boundary-Scan-Architecture, Draft, November 22, 1989). Bei einer diesem Standard entsprechenden Schaltungsanordnung werden insbesondere Testmuster in einen speziell zum Testen freigeschalteten Schaltungsblock über externe Anschlüsse seriell eingelesen und nach Abarbeitung durch den Schaltungsblock das sich so ergebende Ausgangstestmuster seriell ausgelesen. Auf diese Weise wird jeder einzelne Block nacheinander für sich freigeschaltet und einzeln getestet.

Heutzutage werden in einem Baustein häufig neuartige oder auch bereits einzeln existierende Schaltungsblöcke (Makros) eingesetzt. Werden diese Schaltungsblöcke mehrfach eingesetzt, so führt dies zu einer Vervielfachung der Testzeit aufgrund der seriellen Durchführung der an sich gleichen Tests, was sich über die Testkosten auch auf die Bausteinkosten auswirkt.

Die EP 0 059 789 A offenbart ein aus drei gleichartigen Rechnern gebildetes Rechnersystem mit Busleitungen zur Versorgung des Rechnersystems mit Prozessdaten und Ausgabekanälen zum Liefern von Datentelegrammen. Zum Ausgeben von Daten auf die Ausgabekanäle weist das Rechnersystem eine Datenausgabeeinrichtung aus drei Multiplexerschaltern auf. An zwei Eingänge jedes Multiplexerschalters sind jeweils zwei der drei Rechner angeschlossen, und zwar in einer Kombination, die verschieden ist von der Rechnerkombination, die auf die anderen Multiplexerschalter aufgeschaltet ist. Für den Vergleich der von den Rechnern gelieferten Datentelegramme sind Vergleicher vorgesehen, wobei ein Eingang jedes Vergleichers an einen Ausgang eines der Rechner und ein anderer Eingang an einen Ausgang desjenigen Multiplexerschalters angeschlossen ist, dessen Eingänge auf die beiden anderen Rechner geführt sind. Jeder Vergleicher vergleicht die von jeweils zwei Rechnern zugeführten Datentelegramme und meldet ein entsprechendes Ergebnissignal an eine Multiplexer-Steuereinrichtung. Wenn die Datentelegramme von zwei Rechnern nicht übereinstimmen, so lokalisiert die Multiplexer-Steuereinrichtung eine Störung.

Aufgabe der Erfindung ist es, eine Schaltungsanordnung mit mehreren identischen Schaltungsblöcken anzugeben, die in kürzerer Zeit getestet werden kann.

Die Aufgabe wird gelöst durch eine Schaltungsanordnung gemäß Patentanspruch 1. Ausgestaltungen und Weiterbildungen des Erfindungsgedankens sind Gegenstand von Unteranspruchen.

Erfindungsgemäß werden im Testbetrieb alle identischen Schaltungsblöcke eingangsseitig einander parallel geschaltet und ihre Ausgangssignale mittels einer Vergleichseinrichtung miteinander verglichen. Von den identischen Schaltungsblöcken kann dabei ein einziger eingangsseitig und ausgangsseitig nach außen geschaltet werden, dessen Funktionsfähigkeit damit absolut geprüft werden kann und die anderen dazu identischen Schaltungsblöcke mit diesem einen Schaltungsblock verglichen werden.

Zum Vergleichen der einzelnen Schaltungsblöcke können die Ausgangssignale der Schaltungsblöcke über EXOR-Gatter miteinander verknüpft werden und jeweils beim Auftreten eines Abtaststeuersignals (Strobe-Signals) abgetastet werden. Das Ergebnis dieses Vergleichs kann mittels eines Flip-Flops und eines Multiplexers über einen Ausgangsanschluß, beispielsweise den TDO-Ausgangsanschluß bei einem Boundary-Scan-Interface, ausgegeben werden. Bei fehlerfreiem Test liegt an diesem Ausgangsanschluß beispielsweise der logische Zustand "L" an, der bei Auftreten eines Fehlers auf den logischen Zustand "H" wechselt. Das Strobe-Signal wird aus einer Flanke eines über einen Eingangsanschluß extern zugeführten Testtaktsignals hergeleitet und ist im Vergleich zu diesem relativ kurz. Durch das Strobe-Signal wird ein fester Abtastzeitpunkt für alle Ausgänge des Schaltungsblocks erreicht, wobei alle Ausgangssignale der Schaltungsblöcke in allen Taktphasen überprüft werden. Darüber hinaus ist eine zeitliche Bestimmung des Fehlers möglich.

Es können auch zwei Strobe-Signale erzeugt werden, von denen das eine beispielsweise aus der fallenden und das andere aus der steigenden Flanke des extern zugeführten Taktsignals hergeleitet werden. Die beiden Strobe-Signale dienen zum Vergleich zweier unabhängiger Gruppen von Ausgangssignalen. Durch zwei Abtastzeitpunkte ist es beispielsweise möglich, am Ende des Zustands "H" des externen Taktsignals und zum Ende des Zustands "L" an unterschiedlichen Ausgängen der Schaltungsblöcke einen Vergleich durchzuführen. Dabei können durch ein asymmetrisches externes Taktsignal die Abtastzeitpunkte weitgehend frei gewählt und variiert werden.

Unter der Voraussetzung, daß im Testfall genügend externe Anschlüsse am Baustein zur Verfügung stehen, kann eine der Anzahl der Ausgänge der Schaltungsblöcke entsprechende Anzahl von Strobe-Anschlüssen vorgesehen werden, über die externe Strobe-Signale zugeführt werden können. Daraus ergibt sich für jeden Ausgang ein frei wählbarer Abtastzeitpunkt, so daß beispielsweise die Ausgänge nur bei interessierenden Zyklen verglichen werden können.

Desweiteren kann ein Fehlerregister vorgesehen werden, bei dem jeweils ein Bit einem der identischen Schaltungsblöcke zugeordnet ist. Das Ausgangssignal der Vergleichseinrichtung oder der Abtasteinrichtung setzt je nach Schaltungsblock bei Auftreten eines Fehlers ein entsprechendes Bit in diesem Register. Fallen mehrere Schaltungsblöcke im gleichen Takt aus, so können auch mehrere Bits gesetzt sein. Nach dem erstmaligen Setzen des Registers kann dieses gesperrt werden, um eine Fehlinterpretation durch nachfolgende Fehler zu vermeiden. Am Testende kann das Fehlerregister ausgelesen werden und der zuerst ausfallende Schaltungsblock so lokalisiert werden. Mit Hilfe des Fehlerregisters läßt sich beispielsweise der Ausfalltakt bestimmter Schaltungsblöcke bestimmen.

Ebenso kann ein Ausgangsfehlerregister realisiert werden, bei dem jeweils ein Bit des Registers einem Ausgang der Schaltungsblöcke zugeordnet ist. Die Bits im Ausgangsfehlerregister werden beispielsweise durch die Vergleichseinrichtung oder die Abtasteinrichtung gesetzt. Am Testende kann das Register ausgelesen werden, und so der fehlerhafte Ausgang lokalisiert werden. Über den externen Testdatenausgang ist zudem die Bestimmung des Ausfalltaktes möglich.

Bei einer Ausführungsform werden sowohl ein Blockfehlerregister als auch ein Ausgangsfehlerregister vorgesehen. Bei Auftreten eines oder mehrerer Fehler werden die Register beschrieben und ihr Inhalt seriell über einen Testdatenausgangsanschluß nach außen geschoben. Dabei wird das Signal am Testdatenausgangsanschluß beispielsweise ständig auf dem logischen Zustand "L" gehalten, im Fehlerfall zunächst ein Zustand "H" herausgeschoben und danach der Inhalt beider Register seriell in geeigneter Form ausgegeben. Die Reihenfolge der einzelnen Bits bzw. der Register und die eventuelle Einstreuung von Erkennungsbits kann dabei beliebig erfolgen. Damit wird erzielt, daß die Register am Testende nicht explizit ausgelesen werden müssen, sondern das Vergleichsergebnis nach einem Fehler in den nachfolgenden Takten seriell am Testdatenausgangsanschluß anliegt. Darüber hinaus können auch mehrfach Fehler detektiert werden, in dem einige Takte nach Auftreten eines Fehlers die Register wieder gelöscht werden und bei Auftreten eines erneuten Fehlers die Signalisierung des Fehlers in der eben beschrieben Weise erneut stattfinden kann.

Bei einer anderen Ausführungsform werden keine Ausgänge für Ausgangstestmuster nach außen geschaltet, sondern es wird über weitere Eingangsanschlüsse ein Vergleichsvektor angelegt. Dieser Vektor wird mit den Ausgangstestmustern aller identischen Schaltungsblöcke verglichen und nur das Ergebnis nach außen geschaltet, oder in einem Blockfehler- und Ausgangsfehlerregister abgelegt. Die beiden Register können wie bereits beschrieben auf verschiedene Art und Weise ausgewertet werden. Diese Ausführungsform hat den Vorteil, daß eine große Zahl von Multiplexern und Ausgängen eingespart werden kann, die insbesondere dann notwendig ist, wenn im Normalbetriebsfall die betroffenen Schaltungsblöcke keine oder nur wenige Ausgangssignale nach außen abgeben. Es ergibt sich daraus eine in der Regel einfachere Signalfuhrung beim Baustein-Layout.

Bei einer weiteren Ausführungsform ist der Baustein als integrierter Schaltkreis ausgeführt. Dieser enthält mindestens eine serielle Schnittstelle, mittels derer die Eingangstestmuster eingegeben und/oder die Ausgangstestmuster ausgegeben und/oder der Vergleichsvektor eingegeben werden können. Hierbei kann die Taktfrequenz des Bausteins und die Datenrate der seriellen Schnittstellen voneinander abweichen. Vorteilhaft ist es, daß keine zusätzlichen Anschlüsse und Multiplexer benötigt werden.

Weiterhin kann vorgesehen werden, daß die Vergleichseinrichtung mit in den Schaltkreis integriert ist und das Vergleichsergebnis im Testfall über unbenutzte Ausgangsanschlusse nach außen geschaltet wird. Diese Ausgangsanschlüsse werden dabei extern mittels eines Strobe-Signals abgetastet. Somit ist kein Zuführen von Strobe-Signalen in den Baustein notwendig.

Ändern sich die verschiedenen Ausgangssignale der einzelnen Schaltungsblöcke alle zu einer oder wenigstens zu fest definierten Zeiten, wie beispielsweise nach einem Taktimpuls, und sind alle Ausgänge durch vollständigen Reset hinreichend definiert, so können auch noch die verschiedenen Vergleichssignale intern UND-verknüpft werden und es reicht letztlich ein einziges Vergleichssignal aus, das gegebenenfalls extern zu verschiedenen, durch das Strobe-Signal vorgegebenen Zeitpunkten abgetastet werden muß.

Die Erfindung wird nachfolgend anhand der in den Figuren der Zeichnung dargestellten Ausführungsbeispiele näher erläutert. Es zeigt:
- Figur 1: eine erste Ausführungsform einer erfindungsgemäßen Schaltungsanordnung und
- Figur 2: eine zweite Ausführungsform einer erfindungsgemäßen Schaltungsanordnung.

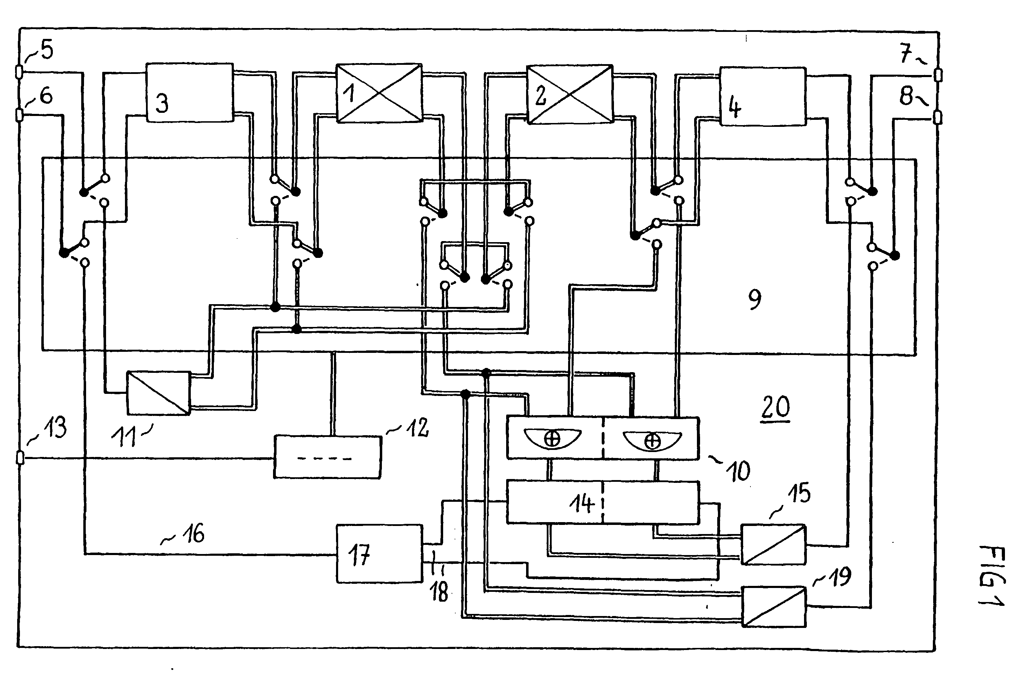

Bei der erfindungsgemäßen Schaltungsanordnung nach Figur 1 sind zwei identische Schaltungsblöcke 1 und 2 sowie eine Eingabeeinheit 3 und eine Ausgabeeinheit 4 vorgesehen. Über zwei Eingangsanschlüsse 5 und 6 sollen dabei externe Signale zuführbar und über zwei Ausgangsanschlüsse 7 und 8 sollen Ausgangssignale abnehmbar sein. Die Eingangsanschlüsse 5 und 6, die Eingabeeinheit 3, die Schaltungsblöcke 1 und 2, die Ausgabeeinheit 4 sowie die Ausgangsanschlüsse 7 und 8 stehen mit einer Schalteinrichtung 9 derart in Verbindung, daß im Normalbetriebsfall die Eingabeeinheit 3 auf die Eingangsanschlüsse 5 und 6 sowie die Ausgabeeinheit 4 auf die Ausgangsanschlüsse 7 und 8 aufgeschaltet sind, wobei die Schaltungsblöcke 1 und 2 beispielsweise in Reihe zueinander zwischen die Eingabeeinheit 3 und die Ausgabeeinheit 4 geschaltet sind. Im Testbetriebsfall werden die Schaltungsblöcke 1 und 2 eingangsseitig parallel geschaltet und ihre Ausgangssignale einer Vergleichseinrichtung 10 zugeführt. An die Eingänge der Schaltungsblöcke 1 und 2 werden dabei Eingangstestmuster angelegt. Die Eingangstestmuster werden beim vorliegenden Ausführungsbeispiel durch einen Seriell-Parallel-Umsetzer 11 bereitgestellt, der eingangsseitig im Testbetriebsfall auf den Eingangsanschluß 5 aufgeschaltet ist. Die Eingangstestmuster werden dabei über den Eingangsanschluß seriell in den Seriell-Parallel-Umsetzer 11 eingegeben.

Die Steuerung der Schalteinrichtung 9 erfolgt beispielsweise mittels eines Testregisters 12, das seinerseits über einen Testmodusanschluß 13 steuerbar ist. Im Testregister 12 ist die Schaltfolge der Schalteinrichtung 9 abgelegt, die durch ein entsprechendes Signal am Testmoduseingang 13 aktiviert wird.

Die Ausgangstestmuster der beiden Schaltungsblöcke 1 und 2 können beim vorliegenden Ausführungsbeispiel in zwei unterschiedliche Gruppen eingeteilt werden. Diese beiden Gruppen werden jeweils für sich untereinander durch die Vergleichseinrichtung 10 zwei unterschiedliche Vergleichsergebnisse bildend miteinander verglichen. Der Vergleich erfolgt beispielsweise durch EXOR-Verknüpfung sich jeweils entsprechender Bits der von den Schaltungsblöcken 1 und 2 abgegebenen Ausgangstestmustern. Die Vergleichsergebnisse werden gruppenweise abwechselnd von einer Abtasteinrichtung 14 abgetastet und die daraus resultierenden Abtastwerte einem Parallel-Seriell-Umsetzer 15 zugeführt. Der Abtastzeitpunkt der einen Gruppe hängt dabei von der steigenden Flanke und der Abtastzeitpunkt der anderen Gruppe von der fallenden Flanke eines Testtaktsignals 16 ab. Das Testtaktsignal 16 wird im Testbetriebsfall über den Eingangsanschluß 6 und die Schalteinrichtungen 9 einer Signalaufbereitungseinrichtung 17 zugeführt,die daraus Steuersignale 18 zur Steuerung der Abtasteinrichtung 14 erzeugt. Schließlich ist ein Parallel-Seriell-Umsetzer 19 vorgesehen, der eingangsseitig mit den Ausgängen des ersten Schaltungsblocks 1 verbunden ist und dessen serieller Ausgang über die Schalteinrichtung 9 im Testbetriebsfall auf den Ausgangsanschluß 8 aufgeschaltet ist. Das Ausgangstestmuster des Schaltungsblocks 1 lassen sich folglich über den Ausgangsanschluß 8 seriell auslesen.

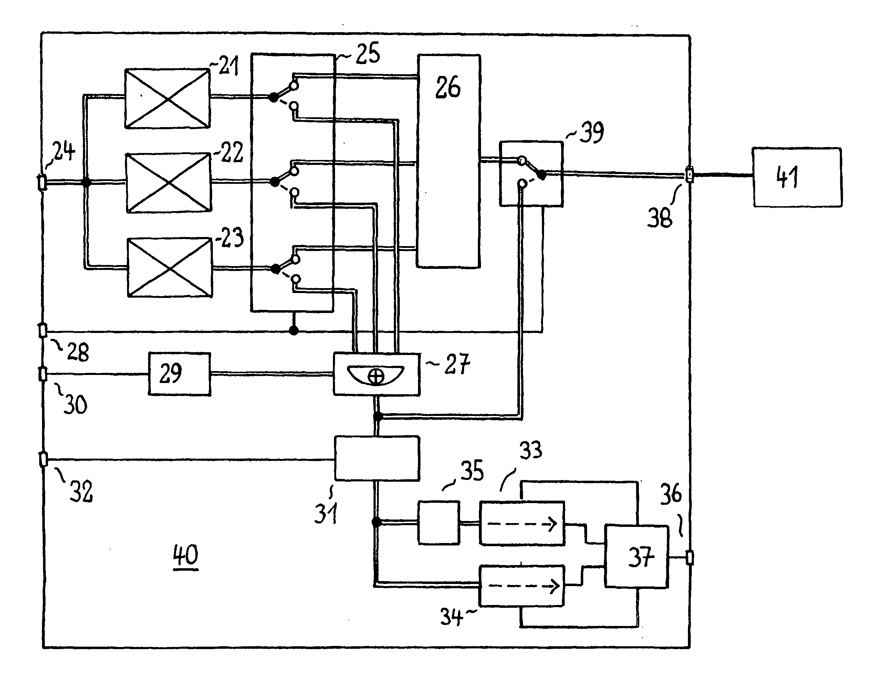

Bei dem Ausführungsbeispiel nach Figur 2 sind drei identische Schaltungsblöcke 21, 22 und 23 bei einem integrierten Schaltkreis 40 vorgesehen. Die Schaltungsblöcke 21, 22 und 23 sind sowohl im Normalbetriebsfall als auch im Testbetriebsfall einander parallel geschaltet und über mehrere Eingangsanschlüsse 24 von außen ansteuerbar. Die Ausgänge der Schaltungsblöcke 21, 22 und 23 sind mit einer Schalteinrichtung 25 verbunden, die die Ausgänge der Schaltungsblöcke 21, 22 und 23 im Normalbetriebsfall auf eine Ausgabeeinheit 26 und im Testbetriebsfall auf eine Vergleichseinrichtung 27 aufschaltet. Die Schalteinrichtung 25 ist beispielsweise als Dreifachdatenmultiplexer ausgeführt, der durch ein über einen Eingangsanschluß 28 zugeführtes Steuersignal für den jeweiligen Betriebsfall umgeschaltet wird.

Die Vergleichseinrichtung 27 vergleicht im Testbetriebsfall die Ausgangstestmuster der Schaltungsblöcke 21, 22 und 23 jeweils mit einem Vergleichsvektor, der von einem Seriell-Parallel-Umsetzer 29 bereitgestellt wird. Der Seriell-Parallel-Umsetzer 29 wird seinerseits über einen Eingangsanschluß 30 seriell mit dem Vergleichsvektor versorgt. Die Vergleichsergebnisse der Vergleichseinrichtung 27 werden durch eine Abtasteinrichtung 31 zu bestimmten, von einem über einen Eingangsanschluß 32 zugeführten Strobe-Signal abhängigen Zeitpunkt abgetastet. Vom abgetasteten Vergleichsergebnis werden wiederum abhängig entsprechende Bits in einem Ausgangsfehlerregister 33 und einem Blockfehlerregister 34 gesetzt. Fallen mehrere Schaltungsblöcke im gleichen Takt aus, so können auch mehrere Bits gesetzt werden. Das Ausgangsfehlerregister 33 wird über eine Zuordnungsmatrix 35, die eingangsseitig dem Blockfehlerregister 34 parallel geschaltet ist, gesetzt. Nach dem erstmaligen Setzen des Registers wird dieses gesperrt, um eine Fehlinterpretation durch nachfolgende Fehler zu vermeiden. Im Fehlerfall wird der Inhalt der beiden Register 33 und 34 seriell über einen Ausgangsanschluß 36 herausgeschoben. Die Überwachung der beiden Register 33 und 34 sowie deren Steuerung erfolgt mittels einer Steuereinrichtung 37. Diese erzeugt im Normalfall fortlaufend den logischen Zustand "L". Im Fehlerfall wird zunächst der logische Zustand "H" ausgegeben und danach folgt der Inhalt der beiden Register 33 und 34 beispielsweise nacheinander. Zur Trennung der beiden Registerinhalte sowie zur Zuordnung der Inhalte zum jeweiligen Register werden dabei jeweils spezielle Erkennungsbits gesendet.

Schließlich wird beim vorliegenden Ausführungsbeispiel im Testbetriebsfall der parallele Ausgang der Ausgabeeinrichtung 26 von externen Ausgangsanschlüssen 38 mittels einer weiteren Schalteinrichtung 39 getrennt, sofern die weitere Schalteinrichtung 39 ein entsprechendes Signal über den Eingangsanschluß 28 erhält. Die Ausgangsanschlüsse 38 sind in dem Fall auf den Ausgang der Vergleichseinrichtung 27 aufgeschaltet und ermöglichen somit einen direkten Zugriff auf die Vergleichsergebnisse von außen. Es besteht somit die Möglichkeit, die Vergleichsergebnisse extern abzutasten und auszuwerten. Dies erfolgt beispielsweise durch eine externe Auswerteinrichtung 41.

Neben den als Ausführungsbeispielen gezeigten Ausführungsformen kann die Erfindung auf beliebig strukturierte Schaltungsanordnungen mit einer beliebigen Anzahl von identischen Schaltungsblöcken angewendet werden. Darüber hinaus ist es auch möglich, die Erfindung jeweils für mehrere Gruppen mit jeweils für sich identischen Schaltungsblöcken einzusetzen. Die Erfindung ist auf alle Arten von Bausteinen anwendbar, also in gleicher Weise auf integrierte Schaltkreise und/oder Baugruppen jeweils für sich oder in Verbindung miteinander. Vorhandene Ein-Ausgabeeinheiten insbesondere Parallel-Seriell-Umsetzer und Seriell-Parallel-Umsetzer können dabei auch beim Testbetriebsfall entsprechend verwendet werden.

Bei einem Paralleltest kann auf zeitkritische Tests verzichtet werden, da diese durch funktionale Tests der Bausteingesamtfunktion abgedeckt werden. Es reicht aus, die logische Funktion innerhalb der Schaltungsblöcke zu verifizieren, wodurch Tests an verschiedenen Ausgängen der Schaltungsblöcke zeitlich zusammengefaßt werden können. In der Regel werden dabei durch geringe Unterschiede der einzelnen Schaltungsblöcke im Vergleichsergebnis immer Spikes auftreten. Dem kann durch entsprechende Festlegung des Abtastzeitpunktes begegnet werden. Bei einem taktgesteuerten Baustein beispielsweise mit nur einem Takteingang und nur einer auslösenden Flanke kann der Vergleich kurz vor Ende eines Zyklus erfolgen. Bei Tristate-Ausgängen ist es im Tristate-Fall ausreichend, die internen Tristate-Kontroll-Signale miteinander zu vergleichen, selbst wenn sich die Datenleitungen unterscheiden. Im allgemeinen können die meisten Eingangs- und Ausgangsanschlüsse einschließlich gegebenenfalls vorhandener Schnittstellen durch entsprechende Auslegung der Schalteinrichtungen bzw. durch Verwendung zusätzlicher Schalteinrichtungen sowohl im Normalbetriebsfall als auch im Testbetriebsfall verwendet werden, wodurch sich die Anzahl der insgesamt benötigten Anschlüsse minimieren läßt. Mit der Erfindung wird bereits durch die einfachste Realisierung eine Fehlfunktion aufgefunden. Die Weiterbildungen der Erfindung dienen hauptsächlich der Analyse und Lokalisierung der Fehlfunktion.

Ändern sich die verschiedenen Ausgangssignale der einzelnen Schaltungsblöcke alle zu einer Zeit oder wenigen fest definierten Zeiten, beispielsweise alle nach einem Taktimpuls, und sind alle Ausgänge durch vollständiges Rücksetzen hinreichend definiert, so können auch die verschiedenen Vergleichsergebnisse intern beispielsweise UND-verknüpft werden und es reicht letztendlich ein einziges Vergleichssignal, das gegebenenfalls extern zu verschiedenen Zeitpunkten abgetastet wird, aus.

Weiterhin kann beispielsweise zusätzlich zu einem On-Chip-Paralleltest mittels weiterer Multiplexer die Ausgänge weiterer oder aller einzelnen Schaltungsblöcke sowie anderer Schaltungsteile nach außen geschaltet werden. Für einen Funktionstest ist die Aussage, daß ein Schaltungsblock ausgefallen ist, hinreichend. Eine Fehleranalyse ist jedoch nur durch einen vollständigen Test eines Einzelblocks möglich. Allerdings kann auch hier mit dem erfindungsgemäßen Verfahren Testzeit eingespart werden, da eine genaue Analyse erst dann durchgeführt werden muß, wenn mit dem On-Chip-Test ein Fehler festgestellt worden ist. Die dem Vergleich zugrundeliegenden oder das Vergleichsergebnis darstellenden Daten können darüber hinaus über Testdateneingangs- bzw. Testdatenausgangsanschlüsse nach JTAG-Standard (TDI, TDO) ein- bzw. ausgegeben werden.

## Patentansprüche

1. Schaltungsanordnung mit mehreren in beliebiger Weise miteinander verbundenen identischen Schaltungsblöcken (1, 2; 21, 22, 23) sowie mit mindestens einem Eingangs- und einem Ausgangsanschluß (5, 6, 7, 8, 13; 24, 28, 30, 32, 36, 38), bei der mittels einer gesteuerten Schalteinrichtung (9; 25) die einzelnen Schaltungsblöcke (1, 2; 21, 22, 23) aus der Verbindung miteinander freischaltbar, eingangsseitig mit einem gemeinsamen Eingangsanschluß (5; 24) zur Einspeisung eines Eingangstestmusters koppelbar und ausgangsseitig auf eine Vergleichseinrichtung (10; 27) zum Vergleichen der Ausgangstestmuster der einzelnen Schaltungsblöcke (1, 2; 21, 22, 23) aufschaltbar sind, wobei die Vergleichseinrichtung (10; 27) bei Nichtübereinstimmung der Ausgangstestmuster der einzelnen Schaltungsblöcke (1, 2; 21, 22, 23) ein extern abgreifbares Fehlersignal erzeugt,
**dadurch gekennzeichnet,**
**daß** über einen Eingangsanschluß (6; 32) ein externes Taktsignal oder Strobe-Signal zugeführt wird, und daß mittels einer Abtasteinrichtung (14, 31) das von der Vergleichseinrichtung (10, 27) fortlaufend bereitgestellte Fehlersignal, gesteuert durch das externe Taktsignal oder Strobe-Signal, abgetastet und erst dann die daraus resultierenden Abtastwerte über einen Ausgangsanschluß (7; 36) ausgegeben werden.

2. Schaltungsanordnung nach Anspruch 1,
**dadurch gekennzeichnet,**
**daß** das Ausgangstestmuster mindestens eines Schaltungsblocks auf einen Ausgangsanschluß mittels der Schalteinrichtung (9; 25) aufschaltbar ist.

3. Schaltungsanordnung nach Anspruch 1 oder 2,
**dadurch gekennzeichnet,**
**dass** das externe Taktsignal ein Testtaktsignal ist, das einer Taktaufbereitungseinrichtung (17) zugeführt wird, welche ein durch eine der beiden Flanken des Testtaktsignals getriggertes Abtaststeuersignal mit gegenüber der Periodendauer des Testtaktsignals kurzen Impulsen erzeugt, und daß mittels der Abtasteinrichtung (14, 31) das von der Vergleichseinrichtung (10, 27) fortlaufend bereitgestellte Fehlersignal im Takt des Abtaststeuersignals abgetastet wird.

4. Schaltungsanordnung nach Anspruch 3,
**dadurch gekennzeichnet,**
**daß** die Taktaufbereitungseinrichtung (17) ein auf die andere Flanke des Testtaktsignals getriggertes weiteres Abtaststeuersignal (18) erzeugt und daß die Abtasteinrichtung (14) in Abhängigkeit vom Abtaststeuersignal ein weiteres von der Vergleichseinrichtung (10) für weitere Ausgangstestmuster der Schaltungsblöcke (1, 2) fortlaufend bereitgestelltes Fehlersignal abtastet und die daraus resultierenden Abtastwerte über einen Ausgangsanschluß (7) ausgibt.

5. Schaltungsanordnung nach Anspruch 3 oder 4,
**dadurch gekennzeichnet,**
**daß** das externe Testtaktsignal asymmetrisch ist.

6. Schaltungsanordnung nach Anspruch 1 oder 2,
**dadurch gekennzeichnet,**
**daß** das Strobe-Signal ein externes Abstaststeuersignal ist und daß pro Ausgangstestmuster eines Schaltungsblocks ein externes Abstaststeuersignal über jeweils einen Eingangsanschluß (5) mindestens einer Abtasteinrichtung (14) zugeführt wird, die das zugehörige Fehlersignal im Takt des jeweiligen Abtaststeuersignals abtastet und die daraus resultierenden Abtastwerte über jeweils einen Ausgangsanschluß (7) ausgibt.

7. Schaltungsanordnung nach einem der vorherigen Ansprüche,
**dadurch gekennzeichnet,**
**daß** ein Blockfehlerregister (34) mit einer der Anzahl der Schaltungsblöcke (21, 22, 23) entsprechenden Anzahl von Bits vorgesehen ist und daß bei Auftreten eines Fehlersignals ein dem fehlerhaften Schaltungsblock entsprechendes Bit gesetzt wird.

8. Schaltungsanordnung nach einem der vorherigen Ansprüche,
**dadurch gekennzeichnet,**
**daß** ein von außen lesbares Ausgangsfehlerregister (33) mit einer der Anzahl der Bits der Ausgangstestmuster entsprechenden Bitbreite vorgesehen ist, wobei bei Auftreten eines Fehler-Signals ein dem fehlerhaften Bit eines Ausgangstestmusters entsprechende Bit des Ausgangsfehlerregisters (33) gesetzt wird.

9. Schaltungsanordnung nach Anspruch 8,
**dadurch gekennzeichnet,**
**daß** mindestens ein Blockfehlerregister (34) und mindestens ein Ausgangsfehlerregister (33) vorgesehen sind, und daß bei Auftreten eines Fehlersignals der Inhalt dieser beiden Register (33, 34) seriell über mindestens einen Ausgangsanschluß (36) herausgeschoben wird.

10. Schaltungsanordnung nach einem der vorherigen Ansprüche,
**dadurch gekennzeichnet,**
**daß** der Vergleichseinrichtung (27) über mindestens einen Eingangsanschluß (30) ein Vergleichsvektor zugeführt wird und daß die Vergleichseinrichtung (27) den Vergleichsvektor mit den Ausgangstestmustern der einzelnen Schaltungsblöcke (21, 22, 23) vergleicht und bei Auftreten von Abweichungen ein Fehlersignal erzeugt.

11. Schaltungsanordnung nach einem der vorherigen Ansprüche,
**dadurch gekennzeichnet,**
**daß** zur Eingabe und/oder zur Ausgabe von Testsignalen serielle Schnittstellen (11, 15, 19; 29, 37, 39) vorgesehen sind.

12. Schaltungsanordnung nach einem der vorherigen Ansprüche,
**dadurch gekennzeichnet,**
**daß** die Ausgangstestmuster sich gleichzeitig ändern und daß die Ergebnisse des internen Vergleichs miteinander verknüpft und als einziges Signal nach außen geführt werden.

13. Schaltungsanordnung nach Anspruch 9,
**dadurch gekennzeichnet,**
**daß** nach dem Herausschieben der Registerinhalte das Blockfehlerregister (34) und das Ausgangsfehlerregister wieder gelöscht werden, um bei Auftreten eines weiteren Fehlersignals ein erneutes Herausschieben zu ermöglichen.

## Claims

1. Circuit arrangement having a plurality of identical circuit blocks (1, 2; 21, 22, 23) which are connected to one another in an arbitrary manner and also having at least one input connection and one output connection (5, 6, 7, 8, 13; 24, 28, 30, 32, 36, 38), in which circuit arrangement a controlled switching device (9; 25) can be used to disconnect the individual circuit blocks (1, 2; 21, 22, 23) from one another, to couple their inputs to a common input connection (5; 24) for the purpose of feeding in an input test pattern and to connect their outputs, to a comparison device (10; 27) for comparing the output test patterns from the individual circuit blocks (1, 2; 21, 22, 23), with the comparison device (10; 27) generating an error signal (which can be tapped off externally) when the output test patterns from the individual circuit blocks (1, 2; 21, 22, 23) do not match,
**characterized in that**
an external clock signal or strobe signal is supplied via an input connection (6; 32), and **in that** a sampling device (14; 31) is used to sample the error signal - which is provided continuously by the comparison device (10, 27) - under the control of the external clock signal or strobe signal and only then to output the resultant samples via an output connection (7; 36).

2. Circuit arrangement according to Claim 1,
**characterized in that**
the switching device (9; 25) can be used to apply the output test pattern from at least one circuit block to an output connection.

3. Circuit arrangement according to Claim 1 or 2,
**characterized in that**
the external clock signal is a test clock signal which is supplied to a clock conditioning device (17) which generates a sampling control signal which is triggered by one of the two edges of the test clock signal and has pulses which are short in comparison with the period duration of the test clock signal, and **in that** the error signal which is provided continuously by the comparison device (10, 27) is sampled in time with the sampling control signal by means of the sampling device (14, 31).

4. Circuit arrangement according to Claim 3,
**characterized in that**
the clock conditioning device (17) generates a further sampling control signal (18) which is triggered upon the other edge of the test clock signal, and **in that** the sampling device (14) takes the sampling control Signal as a basis for sampling a further error signal which is provided continuously by the comparison device (10) for further output test patterns from the circuit blocks (1, 2), and outputs the resultant samples via an output connection (7).

5. Circuit arrangement according to Claim 3 or 4,
**characterized in that**
the external test clock signal is asymmetrical.

6. Circuit arrangement according to Claim 1 or 2,
**characterized in that**
the strobe signal is an external sampling control signal, and **in that**, for each output test pattern from a circuit block, an external sampling control signal is supplied via a respective input connection (5) to at least one sampling device (14), which samples the associated error signal in time with the respective sampling control signal and outputs the resultant samples via a respective output connection (7).

7. Circuit arrangement according to one of the preceding claims,
**characterized in that**
a block error register (34) having a number of bits corresponding to the number of circuit blocks (21, 22, 23) is provided, and **in that**, when an error signal occurs, a bit corresponding to the defective circuit block is set.

8. Circuit arrangement according to one of the preceding claims,
**characterized in that**
an output error register (33) which can be read externally and has a bit width corresponding to the number of bits in the output test patterns is provided, with a bit in the output error register (33) which corresponds to the defective bit in an output test pattern being set when an error signal occurs.

9. Circuit arrangement according to Claim 8,
**characterized in that**
at least one block error register (34) and at least one output error register (33) are provided, and **in that** the contents of these two registers (33, 34) are shifted out serially via at least one output connection (36) when an error signal occurs.

10. Circuit arrangement according to one of the preceding claims,
**characterized in that**
a comparison vector is supplied to the comparison device (27) via at least one input connection (30), and **in that** the comparison device (27) compares the comparison vector with the output test patterns from the individual circuit blocks (21, 22, 23) and generates an error signal when discrepancies arise.

11. Circuit arrangement according to one of the preceding claims,
**characterized in that**
serial interfaces (11, 15, 19; 29, 37, 39) are provided for the purpose of inputting and/or outputting test signals.

12. Circuit arrangement according to one of the preceding claims,
**characterized in that**
the output test patterns change simultaneously, and **in that** the results of the internal comparison are combined with one another and passed to the outside as a single signal.

13. Circuit arrangement according to Claim 9,
**characterized in that**,
after the register contents have been shifted out, the block error register (34) and the output error register are erased again in order to allow a new shifting-out operation when a further error signal occurs.

## Revendications

1. Circuit comprenant plusieurs blocs de circuit identiques (1, 2; 21, 22, 23) connectés l'un à l'autre de manière quelconque ainsi qu'au moins une connexion d'entrée et une connexion de sortie (5, 6, 7, 8, 13; 24, 28, 30, 32, 36, 38), dans lequel, au moyen d'un dispositif de commutation commandé (9; 25), les blocs de circuit individuels (1, 2; 21, 22, 23) peuvent être déconnectés de leur connexion mutuelle, couplés côté entrée à une connexion d'entrée commune (5; 24) pour délivrer un échantillon de test d'entrée et connectés côté sortie à un dispositif de comparaison (10; 27) pour comparer les échantillons de test de sortie des blocs de circuit individuels (1, 2; 21, 22, 23), le dispositif de comparaison (10; 27) produisant, lorsqu'il n'y a pas concordance entre les échantillons de test de sortie des blocs de circuit individuels (1, 2; 21, 22, 23), un signal d'erreur qui peut être prélevé à l'extérieur,
**caractérisé en ce que**
un signal d'horloge ou un signal d'impulsion externe est acheminé via une connexion d'entrée (6; 32) et, au moyen d'un dispositif de lecture (14; 31), le signal d'erreur généré en continu par le dispositif de comparaison (10, 27) est lu sous le contrôle du signal d'horloge ou du signal d'impulsion et, seulement ensuite, les valeurs de lecture qui en résultent sont délivrées via une connexion de sortie (7; 36).

2. Circuit selon la revendication 1,
**caractérisé en ce que**
l'échantillon de test de sortie d'au moins un bloc de circuit est connecté à une connexion de sortie au moyen du dispositif de commutation (9; 25).

3. Circuit selon la revendication 1 ou 2,
**caractérisé en ce que**
le signal d'horloge externe est un signal d'horloge de test qui est acheminé d'un dispositif générateur d'horloge (17) qui produit un signal de commande de lecture déclenché par l'un des deux flancs du signal d'horloge de test avec des impulsions courtes par rapport à la période du signal d'horloge de test, et, au moyen du dispositif de lecture (14, 31), le signal d'erreur généré en continu par le dispositif de comparaison (10, 27) est lu au rythme du signal de commande de lecture.

4. Circuit selon la revendication 3,
**caractérisé en ce que**
le dispositif générateur d'horloge (17) produit un autre signal de lecture (18) déclenché par l'autre flanc du signal d'horloge de test et **en ce que** le dispositif de lecture (14) lit, en fonction du signal de commande de lecture, un autre signal d'erreur généré en continu par le dispositif de comparaison (10) pour d'autres échantillons de test de sortie des blocs de circuit (1, 2) et délivre les valeurs de lecture qui en résultent via une connexion de sortie (7).

5. Circuit selon la revendication 3 ou 4,
**caractérisé en ce que**
le signal d'horloge externe est asymétrique.

6. Circuit selon la revendication 1 ou 2,
**caractérisé en ce que**
le signal d'impulsion est un signal de commande de lecture externe et, **en ce que** pour chaque échantillon de test de sortie d'un bloc de circuit, il est acheminé un signal de commande de lecture externe via respectivement une connexion d'entrée (5) au moyen d'au moins un dispositif de lecture (14) qui lit le signal d'erreur associé au rythme du signal de commande de lecture respectif et délivre les valeurs de lecture qui en résultent via respectivement une connexion de sortie (7).

7. Circuit selon l'une quelconque des revendications précédentes,
**caractérisé en ce que**
il est prévu un registre d'erreurs de blocs (34) avec un nombre de bits correspondant au nombre des blocs de circuit (21, 22, 23) et, à l'apparition d'un signal d'erreur, un bit correspondant au bloc de circuit défectueux est activé.

8. Circuit selon l'une quelconque des revendications précédentes,
**caractérisé en ce que**
il est prévu un registre d'erreurs de sortie (33) lisible de l'extérieur avec une largeur de bits correspondant au nombre des bits des échantillons de test de sortie, de sorte qu'à l'apparition d'un signal d'erreur, un bit du registre d'erreurs de sortie (33) correspondant au bit défectueux d'un échantillon de test de sortie soit activé.

9. Circuit selon la revendication 8,
**caractérisé en ce que**
il est prévu au moins un registre d'erreurs de blocs (34) et au moins un registre d'erreurs de sortie (33) et, à l'apparition d'un signal d'erreur, le contenu de ces deux registres (33, 34) est extrait en série via au moins une connexion de sortie (36).

10. Circuit selon l'une quelconque des revendications précédentes,
**caractérisé en ce que**
un vecteur de comparaison est acheminé au dispositif de comparaison (27) via au moins une connexion d'entrée (30) et le dispositif de comparaison (27) compare le vecteur de comparaison aux échantillons de test de sortie des blocs de circuit individuels (21, 22, 23) et produit un signal d'erreur à l'apparition d'écarts.

11. Circuit selon l'une quelconque des revendications précédentes,
**caractérisé en ce que**
il est prévu des interfaces sérielles (11, 15, 19; 29, 37, 39) pour la saisie et/ou la délivrance de signaux de test.

12. Circuit selon l'une quelconque des revendications précédentes,
**caractérisé en ce que**
les échantillons de test de sortie se modifient simultanément et les résultats de la comparaison interne sont combinés les uns avec les autres et sont acheminés à l'extérieur sous la forme d'un seul signal.

13. Circuit selon la revendication 9,
**caractérisé en ce que**
après extraction des contenus de registres, le registre d'erreurs de blocs (34) et le registre d'erreurs de sortie sont à nouveau effacés pour permettre une nouvelle extraction à l'apparition d'un autre signal d'erreur.
